(19) **Europäisches Patentamt**

**European Patent Office**

**Office européen des brevets**

(11) **EP 0 746 887 B1**

(12) **EUROPEAN PATENT SPECIFICATION**

(45) Date of publication and mention
of the grant of the patent:
**02.11.2000 Bulletin 2000/44**

(51) Int. Cl.[7]: **H01S 5/10**, G02B 6/42,
H01L 33/00, G02B 6/30

(21) Application number: **95909047.3**

(22) Date of filing: **24.02.1995**

(86) International application number:
**PCT/GB95/00387**

(87) International publication number:
**WO 95/23445 (31.08.1995 Gazette 1995/37)**

(54) **SEMICONDUCTOR DEVICE**

HALBLEITERVORRICHTUNG

DISPOSITIF A SEMI-CONDUCTEUR

(84) Designated Contracting States:
**AT BE CH DE DK ES FR GB GR IE IT LI LU MC NL
PT SE**

(30) Priority: **24.02.1994 EP 94301309**

(43) Date of publication of application:
**11.12.1996 Bulletin 1996/50**

(73) Proprietor:
**BRITISH TELECOMMUNICATIONS public limited
company
London EC1A 7AJ (GB)**

(72) Inventors:
• **LEALMAN, Ian, Francis
Ipswich Suffolk IP4 5BT (GB)**
• **ROBERTSON, Michael, James
Ipswich Suffolk IP1 4LJ (GB)**

(74) Representative:
**Roberts, Simon Christopher et al
BT Group Legal Services,
Intellectual Property Department,
8th Floor, Holborn Centre
120 Holborn
London, EC1N 2TE (GB)**

(56) References cited:
**EP-A- 0 545 820        GB-A- 2 195 822**

• ELECTRONICS LETTERS., vol.28, no.17, 13
August 1992, STEVENAGE, HERTS, GB pages
1610 - 1611 N. YOSHIMOTO ET AL 'Spotsize
convertor using InP/InAlAs MQW waveguides
for low-loss single mode fibre coupling' cited in
the application
• APPLIED PHYSICS LETTERS., vol.64, no.5, 31
January 1994, NEW YORK US pages 539 - 541 P.
DOUSSIERE ET AL 'tapered active stripe for 1.5
mum InGaAsP/InP strained multiple quantum
well lasers with reduced beam divergence'
• ELECTRONICS LETTERS., vol.25, no.20, 28
September 1989, STEVENAGE, HERTS, GB
pages 1355 - 1356 R.J. DERI ET AL 'Low loss
optical directional coupler in InP'
• PATENT ABSTRACTS OF JAPAN vol. 7, no. 222
(E-201) 4 October 1983 & JP,A,58 114 476
(KOKUSAI DENSHIN DENWA KK)
• IEEE PHOTONICS TECHNOLOGY LETTERS,
vol.2, no.2, 2 February 1990, NEW YORK US
pages 88 - 90 T. L. KOCH ET AL 'Tapered
waveguide InGaAS/InGaAsP multi quantum well
lasers' cited in the application
• ELECTRONICS LETTERS., vol.29, no.4, 18
February 1993, STEVENAGE, HERTS, GB pages
392 - 393 T. NAMEGAYA ET AL 'High temperature
operation of 1.3 mum GaInAsP/InP Grinsch
strained layer quantum well lasers' cited in the
application
• PATENT ABSTRACTS OF JAPAN vol. 11, no. 245
(E-531) 11 August 1987 & JP,A,62 058 692
(FURUKAWA ELECTRIC CO LTD)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Xerox (UK) Business Services
2.16.7 (HRS)/3.6

**(Cont. next page)**

- ELECTRONICS LETTERS., vol.30, no.12, 9 June 1994, STEVENAGE, HERTS, GB pages 973 - 975 I.F. LEALMAN ET AL 'Low threshold current 1.6 mum InGaAsP/InP tapered active layer MQW laser with improved couipling to cleaved singlemode fibre'

**Description**

The present invention relates to a semiconductor optical device, and to a method for fabricating a semiconductor optical device, and in particular to a semiconductor optical device which is adapted to form a low loss interconnection with an optical fibre.

The development of semiconductor devices and optical fibres, for example for use in optical communications systems, has occurred very much in isolation from each other. Semiconductor devices, for example lasers, have been developed and optimised with their own particular requirements in mind, for example for lasers, low threshold, high bandwidth, narrow linewidth and high output power are all desirable. These requirements, in combination with the fundamental limitations imposed by the available semiconductor materials, in particular their refractive index, has meant that very small waveguide modes have been essential in order to optimise the functionality of these semiconductor optical devices. In contrast, the requirements for optical fibres have been the need for low loss, low material and waveguide dispersion, a range of mechanical properties (including being handleable), and the ability to be spliced. Although the progression from multi-mode to single mode fibres has seen a reduction in the waveguide mode size for optical fibres, the mode size for single mode fibres which in practice can be spliced, is very much larger than the waveguide mode sizes found in semiconductor optical devices. The spot size ($1/e^2$ diameter) of standard telecommunications single mode optical fibre at a wavelength of 1.55 μm is approximately 10 μm, whereas the spot size at the output facet of a typical double heterostructure semiconductor laser is 1.0 μm by 1.5 μm.

This large mismatch between the mode spot sizes of semiconductor optical devices and optical fibres means that coupling efficiencies between the two are very low, for example as low as 10% for a laser and a cleaved single mode fibre. In addition, tight alignment tolerances are required in order to maximise the coupling efficiency between a semiconductor laser and an optical fibre, which dramatically increases the cost of packaging semiconductor devices. One of the key economic requirements for the implementation of FTTH (fibre to the home) is the availability of low cost packaged semiconductor lasers. The largest proportion of the cost of the laser is incurred in packaging the device, and a major contribution to this cost is the need to use sub-micron active fibre alignment techniques to align the fibre to the semiconductor laser.

A technique for increasing the coupling efficiency between semiconductor devices and optical fibre is described in "Low Loss Coupling Between Semiconductor Laser And Single Mode Fibre Using Tapered Lensed Fibres" I W Marshall, British Telecom Technology Journal, Vol. 4, No. 2, April 1986. This paper describes how lenses can be formed on the end of single mode fibres by first drawing the fibre to a taper, by holding it under tension in the arc of a fusion splicer, and then forming a lens by melting the tip of the taper. While this technique does indeed increase the coupling efficiency between the fibre and the semiconductor laser, it significantly increases the cost of packaging these devices. In addition to the cost of actually forming the lens, higher alignment tolerances are required when such a lens is utilised, relative to those required with a cleaved fibre end. This arises because the sensitivity of the coupling loss to misalignment of the lensed fibre increases as the lens radius decreases, so that alignment tolerances must be traded for increased coupling efficiency.

An alternative approach to increasing the coupling efficiency between semiconductor optical devices and optical fibres, which also reduces the alignment tolerances required when packaging these devices, comprises the use of passive mode converters. Such devices are described in, for example, "Highly Efficient Fibre Waveguide Coupling Achieved By InGaAsP/InP Integrated Optical Mode Shape Adapters" presented at European Conference on Optical Communications 1993 by T Brenner and H Melchior and "Spot Size Converters Using InP/InAlAs Multiquantum Well Waveguides For Low Loss Single Mode Fibre Coupling" Electronic Letters 1992, Vol. 28, pp 1610-1617, N Yoshimoto et al. These devices are passive optical components which serve to optically connect single mode fibres to semiconductor devices by utilising tapered waveguide sections to transform the small semiconductor modes into the much larger mode of a single mode fibre. A very gradual change in the waveguide parameters of these passive mode converters is required to allow the optical mode to expand adiabatically, in order to avoid high losses. Although these passive mode converters do improve the coupling efficiency between semiconductor devices and optical fibres, and also increase the alignment tolerances, they comprise a further component which must be aligned and packaged between the semiconductor optical device and the optical fibre, and thus increase the complexity, size and cost of these packaged devices.

A laser having an integrated passive tapered waveguide which increases its output spot size is described in "Tapered Waveguide InGaAs/InGaAsP Multiple Quantum Well Lasers" T L Koch et al, IEEE Photonics Technology Letters, Vol. 2, No. 2, February 1990. This device employs a conventional multi-quantum well active layer, and a number of passive waveguide layers which are successively etched at different points along the length of the device in order to achieve a stepped, tapered waveguide. The active layer is evanescently coupled to the passive tapered waveguide, and a further passive "outrigger" waveguide spaced a considerable distance from the tapered waveguide, is also employed. The design allows little flexibility for the optimisation of the laser, for example the active layer is limited in thickness by the need to achieve a high degree of evanescent coupling to the passive tapered waveguide. This thickness limit on the active layer limits the high temperature performance of the laser. Furthermore the use of a stepped, tapered passive waveguide requires a large number of additional stages of photolithography, and thus considerably increases the complexity and cost of device fabrication. Patent abstracts of Japan, vol. 7, no. 222 (E-201), 4th October 1983 & JP-A-58 114 476 discloses optically coupling from an active tapered bulk semiconductor region to a passive region, wherein the optical distribution is matched for both regions.

EP-A-0 545 820 (Alcatel) discloses a mode converter wherein both the active and passive regions are tapered and wherein the active region comprises a bulk semiconductor.

According to a first aspect of the present invention there is provided a semiconductor optical device comprising a composite optical waveguide having first and second end surfaces, the composite waveguide comprising:-

a first optically waveguiding region of semiconductor material, which first region is optically passive and is substantially planar, and

a second optically waveguiding region of semiconductor material, which second region is optically active, and is tapered along a substantial part of the length of the second region, from the first end surface to the second end surface of the composite waveguide, in a direction substantially parallel to the plane of the first region, wherein the first and second regions are in optical contact, and wherein the first region is of substantially constant width along the length along the length of the composite waveguide characterised in that the second region comprises a multi-quantum well structure, and in that the dimensions and the refractive indices of the first and second waveguiding regions are selected so that the size of the fundamental optical mode supported by the composite waveguide increases along the length of the composite waveguide.

Thus, in contrast to the device disclosed by Koch et al which comprises an active region of uniform cross-section, and a tapered passive region, a device according to the present invention comprises a tapered multi-quantum well active region in optical contact with a passive planar waveguide. This arrangement gives far greater flexibility in the design of active semiconductor optical devices having large output spot sizes. For example, because the multi-quantum well active region is laterally tapered i.e. tapered in a direction parallel to the plane of the passive waveguide, there is greater flexibility in the allowable thickness of the active layer. This multi-quantum well active layer can be chosen to be sufficiently thick that the device has good high temperature performance, without degrading the degree of optical coupling between the active and passive waveguides. This extra degree of flexibility in design arises because the active region becomes less strongly guiding as it is tapered, and because it comprises a multi-quantum well structure. The use of a multi-quantum well structure allows greater flexability in the design of the composite waveguide, for example, the average refractive index of the active layer can be kept reasonably low, while still ensuring that effective amplification occurs in this active region. The use of a lower refractive index active layer, facilitated by the presence of a multi-quantum well structure, enables the length of the tapered portion of the active region to be reduced. Furthermore, due to the lower average refractive index of a multi-quantum well active region, this active region can be truncated at a larger width, thus reducing the overall device length. Since the costs of a semiconductor device are in part related to the size of the semiconductor chip employed, this reduction in taper length will allow a reduction in device cost.

The use of a multi-quantum well structure active region also facilitates the simplification of the passive waveguiding region, and preferably the passive region is of substantially constant width along the length of the composite waveguide.

The present invention thus provides, for example, a laser having a large spot size output which is better matched to the spot size of standard single mode telecommunications optical fibre, whose other characteristics, for example threshold current, and high temperature performance, have not been unduly compromised. Such large spot size lasers achieve higher coupling efficiencies to optical fibres, and thus allow simple cleaved fibre ends, rather than expensive tapered lensed fibre ends, to be employed. The use of cleaved fibre ends, in combination with a large spot sized laser, may improve the fibre alignment tolerances to such an extent that low cost passive (i.e. without active monitoring of the laser light launched into the fibre) fibre alignment techniques could be employed during the packaging process. Conventional semiconductor laser packages incorporate an active cooling device (e.g. a Peltier element) for maintaining the temperature of the laser chip at a low level, for example at, or below room temperature. A further reduction in the cost of packaged lasers may be achieved if the active cooling device for the laser chip is excluded. This may be possible with lasers according to the present invention because of their good high temperature performance.

Advantageously the tapered part of the optically active region is truncated. Although truncation of the taper does cause loss due to the discontinuity in refractive index experienced by light travelling down the taper, it has surprisingly been found that this truncation loss does not greatly affect the performance of devices according to the present invention. This truncation of the taper allows the taper length to be reduced significantly. Furthermore, it is believed that truncating the taper avoids the undesirable effect of non-radiative recombinations at the edge of the active region which could become significant as the active volume is reduced.

Advantageously the optically active region is tapered in a direction substantially perpendicular to the plane of the passive region. Reducing the height, as well as the width, of the optically active region will further reduce the strength of the optical waveguiding of this region, thus increasing further the size of the optical mode supported by the composite waveguide. Tapering the height of the optically active region may also reduce the loss due to truncation of the taper.

According to a second aspect of the present invention there is provided a method for making a semiconductor optical device, comprising the steps of

1) epitaxially growing a planar wafer comprising an optically waveguiding active region above an optically waveguiding passive region;

2) defining a first mesa comprising the optically waveguiding active region;

3) forming a mask on the first mesa, the width of the mask being less than the width of said first mesa, the mask width varying along the length of the mask; and

4) defining a second mesa, of substantially the same width as the first mesa, said width of the second mesa being substantially constant along its length, which second mesa comprises the optically waveguiding passive region, and redefining the first mesa to correspond to the mask.

The method of the present invention thus provides a simple, two stage, technique for defining a composite waveguide structure having a tapered active region, and a planar passive region. The method has the further advantage that optical and electrical confinement layers can be easily grown right up to the sides of the first and second mesas, for example to form the reversed biassed current blocking layers of a buried hetrostructure device.

The invention will now be described, by way of example only, with reference to the accompanying drawings, in which:

Figure 1 shows a schematic of the composite waveguide structure employed in a large spot size laser according to the invention;

Figure 2 is a graph of the critical taper length against the width of the active waveguide, calculated using Love's method;

Figure 3 is a graph of the single pass loss vs. active waveguide width truncation for a 16 well MQW active layer on a 3.0μm wide, 0.16μm thick passive guide;

Figure 4 shows an epitaxially grown planar wafer;

Figure 5 a) to e) show various stages in the growth of a double mesa structure, of a large spot size laser according to the invention;

Figure 6 a) to d) show further stages in the growth of the double mesa structure from each end of the device;

Figure 7 shows the device after notching, and material transport, with the confinement layers in place;

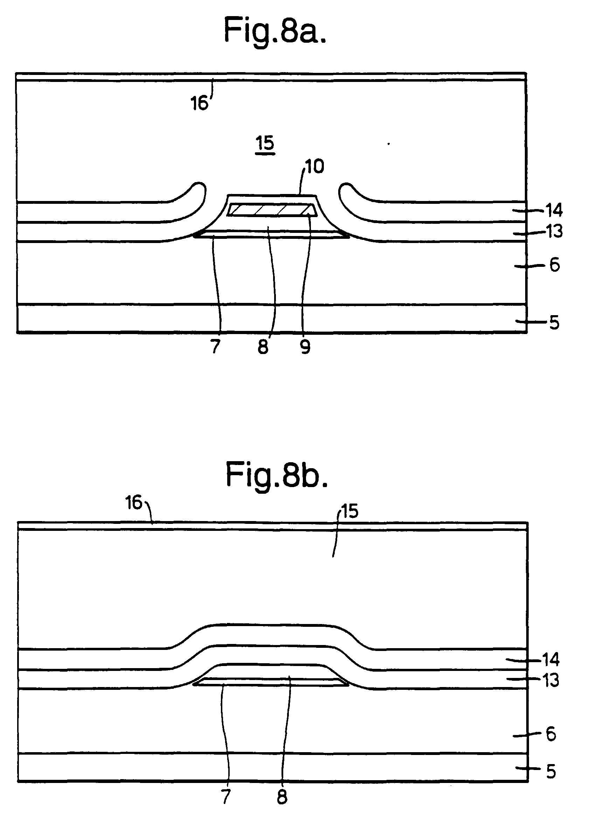

Figure 8 shows the device after second stage overgrowth;

Figure 9 a) and b) show a schematic cross section of the completed device from each end;

Figure 10 is a graph of the threshold current of large spot size lasers according to the invention having different taper lengths, as a function of temperature;

Figure 11 is a graph showing the coupling efficiency of large spot size lasers of different taper lengths to standard cleaved fibre;

Figure 12 is a graph showing the coupling efficiency of large spot size lasers having different taper lengths to cleaved small core fibre;

Figure 13 is a contour plot showing the optical field distribution calculated for a 7 μm wide, 0.07 μm thick, 1.1 μm quaternary passive waveguide with 5 μm InP overgrowth and arsenic doped silica glass (ASG);

Figure 14 is a graph showing the truncation loss against active waveguide width for a 16 well active layer device having the passive waveguide shown in Figure 13;

Figure 15 is a graph showing the critical taper length according to Love's method for a 16 well active layer device having the passive waveguide shown in Figure 13;

Figure 16 is a graph showing truncation loss against active waveguide width for an 8 well strained active layer device having the passive waveguide shown in Figure 13;

Figure 17 shows the critical taper length by Love's method for an 8 well strained active layer device having the passive waveguide shown in Figure 13;

Figure 18 is a graph showing the taper profile for a linear taper, and a three section taper of 60 μm taper length, compared to the critical taper length by Love's method;

Figure 19 is a graph of calculated field profiles for 10μm core single mode fibre and a large spot laser having a 7μm wide, 700Å thick passive region;

Figure 20 is a graph of coupling loss measured to 10μm core cleaved fibre as a function of taper length measured at 50 mA drive current and 20°C, for a large spot size laser having an 8 well MQW active region and 7μm wide,

700Å thick passive region; and

Figure 21 is a graph of coupling loss measured to 10μm core cleaved fibre as a function of taper length measured at 50mA drive current and 20°C for large spot size laser having 8 well MQW active region, and 5μm wide, 800Å thick passive region.

The exemplary embodiment of the present invention is a large spot size laser, although it will be appreciated that the present invention may be advantageously applied to any semiconductor optical device, and that some such devices, for example an optical amplifier, may require the optically active region to be tapered at both of its ends.

When designing a large spot size laser, a number of, sometimes conflicting, design considerations need to be taken into account. The passive waveguide should have a spot size which is well matched to the spot size of the waveguide into which the laser mode is to be launched, for example an optical fibre or an ASG (arsenic doped silica glass) waveguide. The tapered active region needs to be tapered sufficiently slowly so as not to cause excessive loss, and yet sufficiently rapidly so as to give a device of reasonable length. The theoretical basis of these design considerations will now be discussed, before describing the fabrication of a large spot size laser, and the performance of the resulting device.

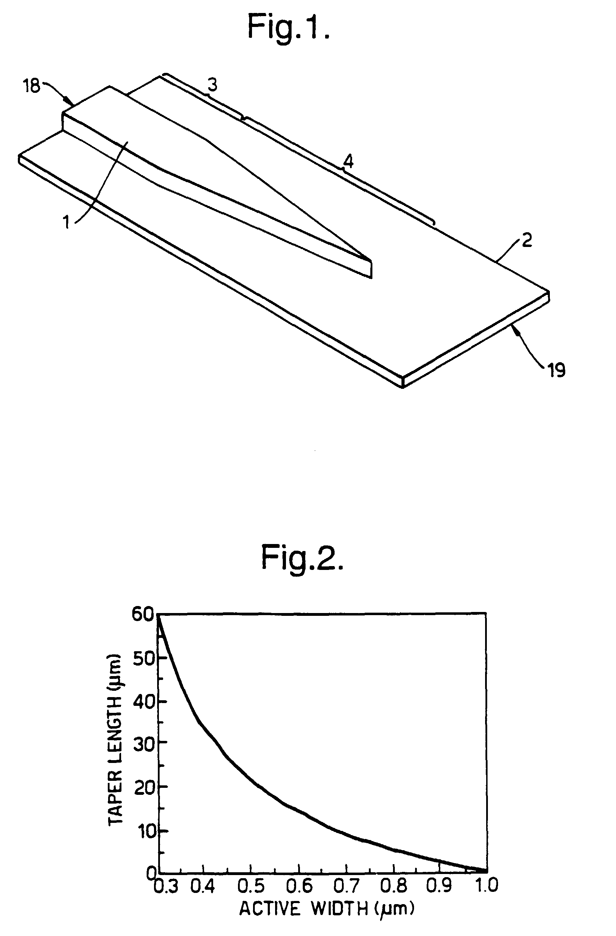

Referring to Figure 1, the composite waveguide structure comprises an MQW (multi-quantum well) active waveguide 1 and a passive planar waveguide 2. The active waveguide comprises a section of constant width 3, and a tapered section 4.

Dealing firstly with the design of the passive waveguide 2. The passive guide structure 2 was modelled using a finite difference programme which indicated that a passive guide 0.16μm thick by 3.0μm wide would give a spot size of 3.8μm by 2.6μm. Where spot size was measured as $1/e^2$ of the guided mode intensity. These results show this structure is a good candidate for the passive guide, since its spot size would be well matched to both cleaved small core fibre and ASG waveguides (which have a spot size of approximately 3.5μm). The choice available for the material wavelength, and therefore refraction index, of the passive guide 2 is fairly broad. The main consideration is that the material wavelength of the passive guide 2 should be less than that of the active region 1 to ensure it is low loss. Reducing the wavelength and therefore refractive index of the passive guide 2 will allow its thickness to be increased, thus giving a degree of design latitude. The passive waveguide should have a thickness and refractive index which ensure that it remains single-moded at the wavelength of operation, for efficient coupling to single mode optical fibre.

The length of the passive waveguide 2 should be greater than the length of the active waveguide 1, so that after the end of the tapered active waveguide the mode of the composite waveguide is allowed to "settle down" before it reaches the front facet of the device. This is desirable because the spot size of the mode at the point where the tapered region is truncated will in general be smaller than the guided mode supported by the passive region. Therefore once the mode passes from the tapered region into the passive region, having incurred some loss at the interface of said regions, it will slowly expand and evolve into the passive waveguide mode. The length of the passive region required to achieve this is dependant on the design of both the active and passive guides.

Turning now to the design of the active waveguide 1 and in particular to the length of the tapered section 4, the method employed to calculate the required taper length is an approximation based on Love's method (see J D Love, W M Henry, W J Stewart, R J Black, S Lacroix and F Gonthier, "Tapered Single Mode Fibres and Devices, Part 1: Adiabaticity Criteria", IEE Proc J, 1991, Vol 138, No. 5, pp343-354) of calculating critical taper lengths for optical fibres. The method is derived from the physical argument that the local taper length must be larger than the coupling length between the fundamental mode and the dominant coupling mode if loss is to be small. A local taper angle is defined by $\Omega(z)=\tan^{-1} dp/dz$, where z is the distance along the taper, and $p=p(z)$ is the local guide radius. In this approximation the local radius $\rho$ is replaced by the local active half width w. The coupling length between the fundamental and second mode is taken to be the beat length $z_b$. Where

$$z_b = \frac{2\Pi}{\beta_1 - \beta_2} \tag{1}$$

and $\beta_1$ and $\beta_2$ are the respective propagation constants. Therefore the local taper angle is given by

$$\Omega = \frac{w(n_1 - n_2)}{2\lambda} \tag{2}$$

where $n_1$ and $n_2$ are the effective indices of the guided modes and in this case $n_2$ is the substrate index if the guide is designed to be single moded. Integrating $\Omega$ over all active widths gives a critical taper length $z_c$. For taper lengths $\gg z_c$ the loss will be small and the taper can be assumed to be adiabatic. While for taper lengths $\ll z_c$ there will be significant loss into the substrate.

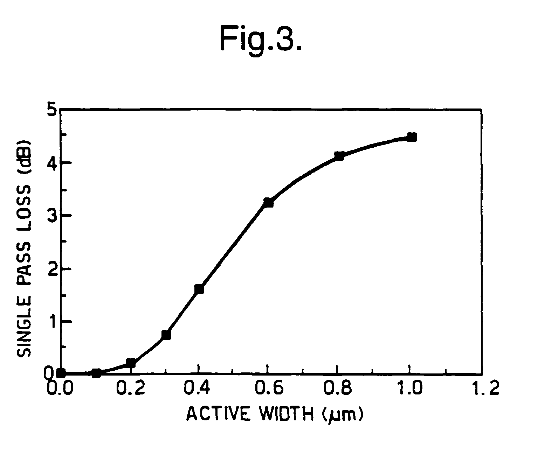

The critical taper length according to these calculations for different widths of active waveguide 1 are plotted in Figure 2. From this it can be seen that as the active waveguide width is reduced, and particularly as it approaches zero, the taper length required for adiabatic mode expansion increases rapidly. Therefore it is important to assess the loss of the composite waveguide structure if the active width is truncated before it has tapered down to zero width. This truncation loss is calculated by carrying out an overlap integration between the passive waveguide mode and the mode in the tapered waveguide at the specified active width. The field profiles required for these integrals are obtained using a finite difference method. The results of this calculation are plotted in Figure 3 and it can be seen that if the active waveguide width is reduced to 0.3μm prior to truncation the single pass loss is <1dB. It should be noted that these loss values assume that the guide taper has been adiabatic up to the point of truncation.

The length of the untapered section 3 of the active waveguide required, depends on the design of the active region, and the length of the taper 4. The length of the untapered section 3 required is reduced as the available gain from the active region is increased, or the length of the tapered section 4 is increased. The amount of gain available from the active region can be increased, in a multiquantum well laser, by increasing the number of wells. This has the effect of reducing the device length required for a specified threshold current. Clearly as the length of the tapered section 4 of the active region is increased, the length of untapered section 3 required will reduce, and it should be noted that with very long taper lengths, for example 800m μm, an untapered section 3 of the active region may not be required at all.

A further advantage in employing a MQW structure active region, as opposed to a bulk semiconductor active region, is that the average refractive index of the active region can be reduced compared to that of a bulk active region. This enables the refractive index of the active region to approach more closely the index of the passive waveguide, with the effect that a lower loss is suffered by the composite mode at the end of the active region.

The fabrication of a large spot size laser will now be described. The process schedule for the fabrication of the large spot size laser is as follows:-

1 Grow planar wafer
2 Define first, wide mesa
3 Define second tapered mesa
4 Notch active layer, heat treat to cause material transport and carry out first stage overgrowth of confinement layers
5 Remove oxide
6 Carry out second stage overgrowth
7 Define ternary mesa
8 Define contact window
9 Thin to 90 μm
10 Deposit p side metal
11 Deposit n side metal

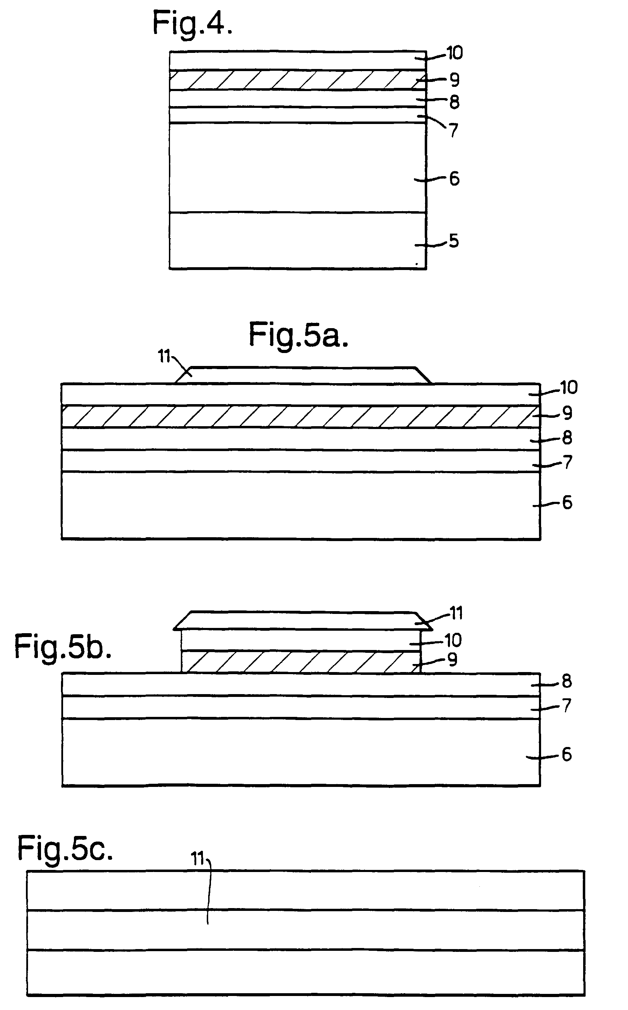

With reference to Figure 4, a planar wafer is grown by conventional MOVPE techniques, comprising an n doped InP substrate 5, an n doped InP buffer layer 6, a 1.1 μm quaternary passive waveguide layer 7 which may be either n doped or undoped, an n doped InP spacer layer 8, an active layer 9, and a p doped top InP layer. Further details of these layers are given in Table 1.

TABLE 1

| Layer | Composition | Thickness | Doping |
|---|---|---|---|
| Cap | InP | 0.2 μm | p5-7e17 |
| Top SCH | 1.3Q | 100 Å | nominally undoped |
| MQW active | See below | 0.268 μm | nominally undoped |
| Bottom SCH | 1.3Q | 100 Å | nominally undoped |
| Spacer layer | InP | 0.2 μm | n 1-2e18 |
| Passive guide | 1.1Q | 0.16 μm | n 1-2e18 |
| Buffer | InP | 3 μm | n 1-2e18 |
| Substrate | InP | 300 μm | n 1-2e18 |

Where the term SCH refers to a separate confinement heterostructure. The MQW active layer is composed of sixteen 80Å (1 nm = 10Å) thick InGaAs wells, separated by fifteen 80Å 1.3 Q barriers, and has an average refractive index of 3.477 at 1.55μm (cf 3.56 for bulk active material designed to lase at 1.55μm).

Since the passive waveguide is fairly weakly guiding the doping of the substrate and buffer layers are matched so as to prevent optical energy being launched into substrate modes.

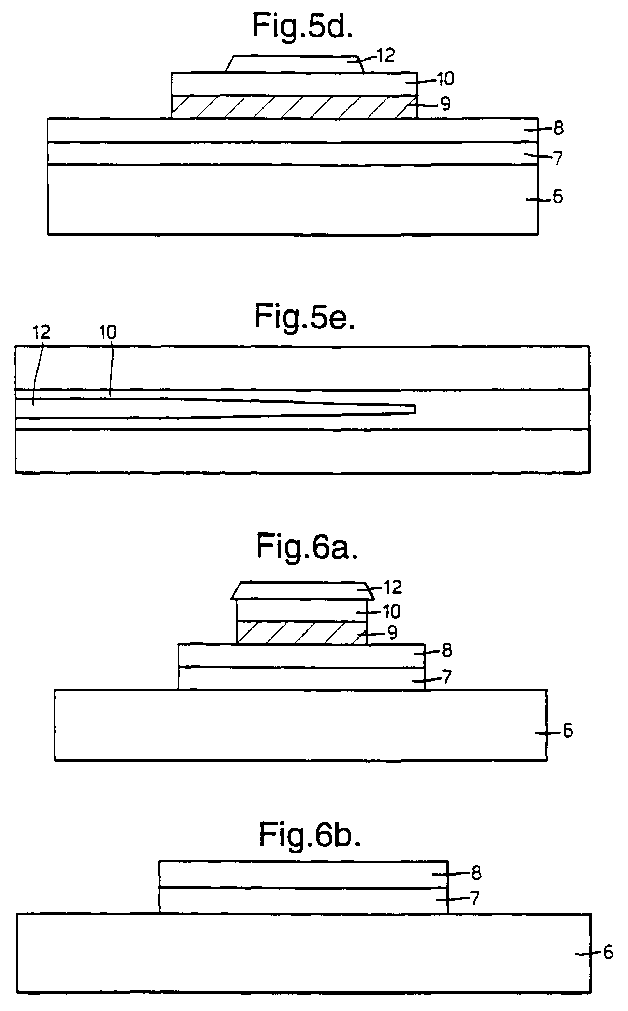

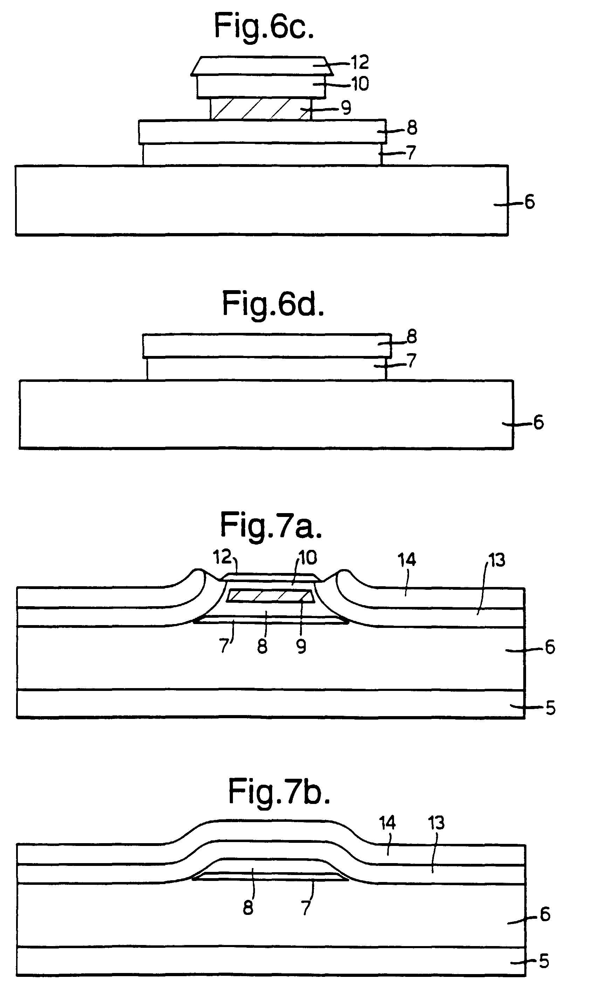

Once the planar wafer has been grown by MOVPE, a silica layer is deposited by CVD (Chemical Vapour Deposition) and a mask 11 (shown in Figure 5) is defined by photolithography and etched in a 10% solution of buffered HF. This silica mask 11 defines the final width of the passive planar waveguide 2. The dimensions of the passive waveguide 2 will depend on the waveguiding properties desired, for the large spot size laser described herein the passive waveguide 2 has a constant width of 3 μm, and extends along the whole length of the device. The first, wide mesa is then etched down to the bottom of the active region 9, as shown in Figure 5b. The mesa is first dry etched using 15% methane/hydrogen reactive ion etching (RIE), to a depth that is within 0.1 μm of the base of the active layer 9. The mesa is then wet etched in 3:1:1 (Sulphuric Acid: Hydrogen Peroxide: Water) to the bottom of the active layer 9. This etchant is selective and stops at the top of the InP spacer layer 8. The plan view of the planar wafer, shown in Figure 5c, shows the constant width of this first mesa. A second stage of silica deposition, photolithography and etching is then carried out, to give a tapered mask 12, shown in Figure 5d and e. This mask 12 defines the final width of the active layer 9. The second, tapered, mesa is now etched by employing a dry etch followed by a wet etch, as for the first mesa. The etch details are the same as above. The thickness of the spacer layer 8 and passive guide 7 are equal to or less than the depth to which the mesa is dry etched. This ensures that the passive guide is completely etched through, since the etch rate of 3:1:1 is strongly dependent on the composition of the guide, and reduces as the material wavelength is shortened. In addition to removing material from the top InP layer 10 and the active layer 9 at either side of the mask 12, this etch also removes material from the spacer layer 8 and passive layer 7 at either side of the first, uniform width, mesa. In this way the terraced structure shown in Figure 6a is formed. Figure 6a shows a schematic cross-section of the device from the direction 18 shown in Figure 1, while Figure 6b shows a schematic cross-section of the same device in the direction 19 shown in Figure 1. The tapered end of the mask 12 has been truncated, as can be seen in Figure 5e, and thus at the end 19 of the device shown in Figure 6b, all of the active layer 9 and top InP layer 10 have been etched away.

The active layer 9 is then "notched' (shown in Figure 6c) by applying an etchant which attacks only the active layer 9. A suitable etchant comprises sulphuric acid, hydrogen peroxide, and water in the ratio 3:1:1. This "notching" of the active layer 9 is believed to provide a clean, fresh surface on the side of the active layer 9, which benefits the subsequent processing steps.

The whole device is then heated to approximately 700°C for 20 minutes in an over pressure of phosphine in order to cause material transport. This treatment converts the mesa shape from that in Figure 6c to that in 7a, and also covers the edge of the active region with InP.

Optical and electrical confinement layers 13 and 14, shown in Figure 7, are grown to the top of the tapered active mesa 1. The first confinement layer 13 comprises 0.5 μm p type InP at 7-8e17, while the second confinement layer 14 comprises 0.4 μm n type InP at 1-2e18. These confinement layers 13 and 14 serve to confine the electrical carriers and the photons generated from recombinations of these carriers, to the active layer 9.

Finally, the device is overgrown with 1.0 μm p type InP at 7-8e17 followed by 1.5 μm of p type InP at 1-2e18 which comprises layer 15 and 0.1 μm of p type InGaAs at >1e19 which comprises the contact layer 16.

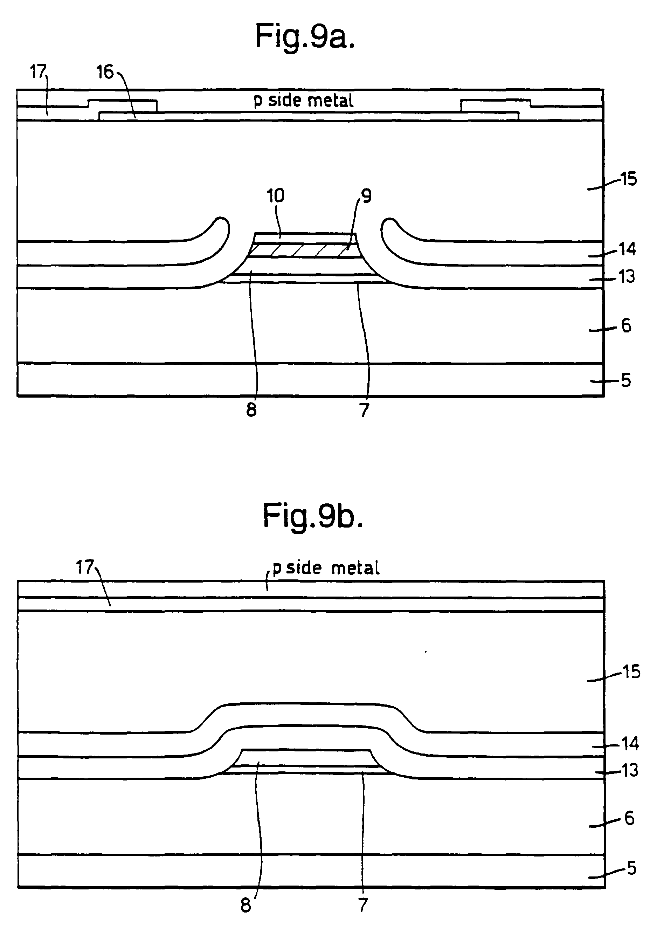

The contact layer 16 is patterned, a silica mask 17 is deposited, and a contact window is defined in this mask 17 in a conventional manner. The device is completed by depositing p and n side titanium-gold metal contacts. Figure 9 shows a schematic cross-section of the completed device, from direction 18 in Figure 9a and from direction 19 in Figure 9b.

A number of large spot size lasers have been fabricated, using tapered masks 12 having different taper lengths 4. The taper lengths employed were 60 μm, 180 μm, 400 μm and 800 μm. Two mask taper profiles were used, a linear taper, and a three section approximation to the critical taper length curve shown in Figure 2.

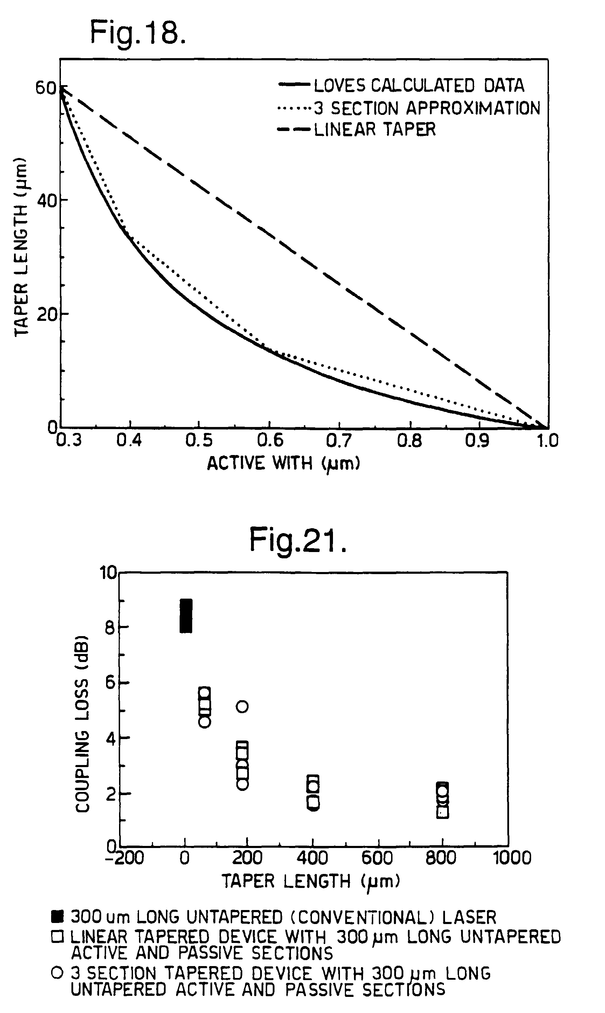

The dimensions of the three section tapers employed are given in Table 2, and Figure 18 shows the three section taper for the 60 μm taper length, together with the 60μm linear taper profile, and the critical taper length curve for 60 μm.

TABLE 2

| Active Width in μm | Taper section lengths in μm | | | |
|---|---|---|---|---|
| | 60 μm taper | 180 μm taper | 400 μm taper | 800 μm taper |
| 1.0-0.6 | 14 | 42 | 92 | 185 |

TABLE 2 (continued)

| | Taper section lengths in µm | | | |
|---|---|---|---|---|
| Active Width in µm | 60 µm taper | 180 µm taper | 400 µm taper | 800 µm taper |
| 0.6-0.4 | 20 | 60 | 134 | 265 |
| 0.4-0.3 | 26 | 78 | 174 | 350 |

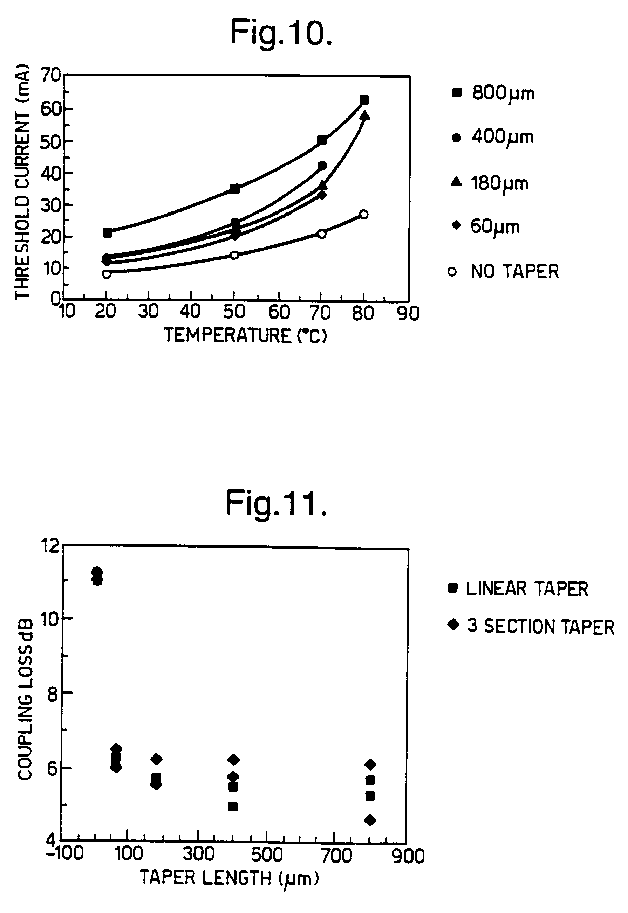

The performance of the large spot size lasers is good, the shorter taper length lasers show only a small increase in threshold current when compared to conventional lasers. The threshold currents for different taper length devices as a function of temperature are shown in Figure 10, as are those for a conventional un-tapered laser. All the devices operated to a high temperature i.e. 70°C, as can be seen from Figure 10.

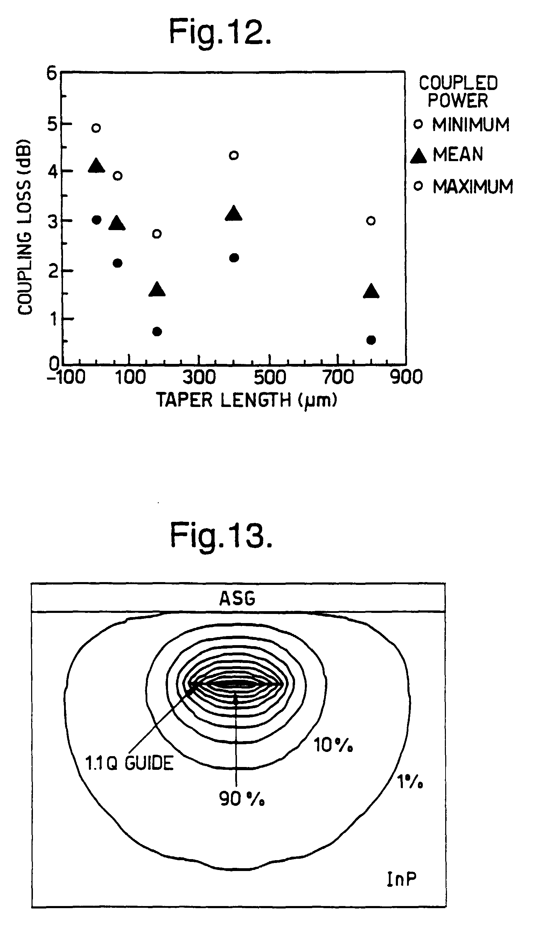

Coupling measurements carried out between these large spot size lasers and cleaved fibres show a significant improvement compared to conventional lasers. Coupling measurements to standard 8-9 µm core optical fibre, are shown in Figure 11, and to small core fibre in Figure 12. The results obtained for standard fibre, show coupling losses down to 4.5dB for the 800µm taper device, which represents a 5 to 6 dB improvement in mean coupling strength over an un-tapered device. It can be seen that the performance of both linear and 3 section taper devices are comparable, and that only a small increase in coupling is obtained as the taper length is increased from 60 to 800 µm. The modest spot size of this device, increased from $\approx$ 1 µm to $\approx$ 3 µm ($1/e^2$ of intensity), meant that no improvement in alignment tolerance was observed for tapered devices when compared to un-tapered devices. In order to increase the alignment tolerance to cleaved fibre, the spot size of the device would need to be enlarged much further. However the use of cleaved fibre as opposed to lens ended fibre increases the 3 dB alignment tolerance from ± 1.5 µm to ± 3.5 µm.

Better results were obtained for coupling to small core fibre ($1/e^2 \approx$ 2.0µm) (as shown in Figure 12) since the laser spot size is better matched to the spot size of this fibre. In this case it can be seen that mean coupling efficiencies of up to - 1.5 dB have been obtained. The 3 dB alignment tolerance of the tapered devices to this small core fibre was ±2.0 µm

In order to improve the coupling loss between large spot size lasers and optical fibre further, a device with a spot size more closely matched to cleaved standard single mode fibre is required. Both design work and experiment work has been carried out which shows it is feasible to fabricate such a device.

If the laser spot size were increased to $\approx$ 8 µm it would closely match the mode size of standard single mode fibre. This could allow losses of 1 dB or less to be obtained when coupling to cleaved standard single mode fibre. One of the first problems encountered is the result of the large spot size. While it is relatively easy to design a passive guide that will give a spot 8 µm by 8 µm it is not so easy to fabricate a device with it. Such a structure would require $\approx$ 8 µm of InP to be grown over the guide if the field in the vertical axis was not to be distorted. Since the maximum thickness that can be easily regrown is $\approx$ 5 µm, this limits the vertical height to less than this. However there are no such constraints on the horizontal spot size. Therefore a guide of 1.1 µm quaternary 7 µm wide by 0.07 µm thick is chosen as the passive guide, since this gives a spot 8 µm wide by 5 µm high whose index and profile are virtually unaffected by the limited overgrowth thickness. The calculations for this structure were carried out using a variable grid finite element programme, and a contour plot of the E-field for this structure is shown in Figure 13.

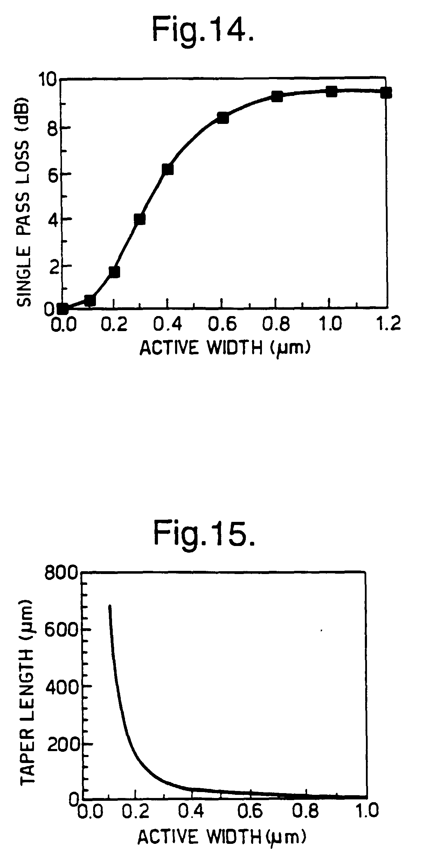

A 16 well MQW active region was initially modelled for the upper active guide structure. The taper length required was calculated using Love's method and the taper length was found to be virtually identical to that shown in Figure 2. However the single pass loss at the truncation point was found to be much larger, (see Figure 14), than previously calculated due to the greater mode expansion. These results indicated that the active width would need to be reduced to 0.1 µm before truncation if this loss was to be kept sufficiently low. This greatly increases the taper length required, (see Figure 15), suggesting that a critical taper length of over 600 µm would be required, greatly increasing device length, and tightening the active width tolerance required.

To improve the active width tolerance, the effect of a reduced active thickness was investigated, both theoretically and experimentally. An eight well strained MQW active region was chosen, since this structure is known to have good high temperature performance. See, for example Nobuhara H, Tanaka K, Yamamoto T, Machida T, Fujii T and Wakao K, "High-Temperature Operation Of InGaAs/InGaAsP Compressive-Strained QW Lasers With Low Threshold Currents", IEEE Photon. Tech. Lett., 1993, 5, (9), pp.961-962, or Namegaya T, Kasukawa A, Iwai N and Kikuta T, "High Temperature Operation Of 1.3µm GaInAsP/InP GRINSCH Strained-Layer Quantum Well Lasers", Electron. Lett., 1993, 29, (4), pp.392-393.

The planar design used in the 8 well device is similar to that of the 16 well device. The planar is epitaxially grown on an n doped InP substrate by atmospheric pressure MOVPE and consists of; a 3µm thick n doped InP buffer layer, a 0.16µm thick n doped 1.1µm wavelength quaternary guide, a 0.2µm thick p doped InP cap. The MQW active layer consists of 8 wells of $In_{0.84}Ga_{0.16}As_{0.68}P_{0.32}$, which have a mismatch of + 1% with respect to InP, and a nominal well thickness of 70Å. The 140Å thick 1.3µm wavelength quaternary barriers are stained -0.5% relative to the substrate to compensate for the strain in the wells. The MQW active layer has an average refractive index of 3.447 at 1.55μm. The MQW structure is surrounded by 100Å thick SCH with the same composition and strain as the barriers. The device is then fabricated into BH lasers as described above.

A comparison of the threshold current at 20°C for unstrained 16 well and strained 8 well low threshold devices are shown in table 3. As can be seen the 8 well devices have room temperature threshold currents of less than half that of the 16 well devices. The threshold current of the 8 well devices remains low at elevated temperatures, with values of ≈ 15mA being observed for devices with 60μm and 180μm tapers at 80°C, Figure 2, compared to ≈ 13mA for untapered 300μm long devices.

TABLE 3

| Device Type | Taper length | | | | |
|---|---|---|---|---|---|
| | None | 60μm | 180μm | 400μm | 800μm |
| Unstrained 16 well MQW | 8.5mA | 11.5mA | 12.6mA | 14.0mA | 20.7mA |
| Strained 8 well MQW | 4.2mA | 4.8mA | 4.9mA | 5.8mA | 7.0mA |

Comparison of unstrained 16 well and strained 8 well MQW laser threshold currents at 20°C vs. taper length for devices with a 300μm long untapered active section.

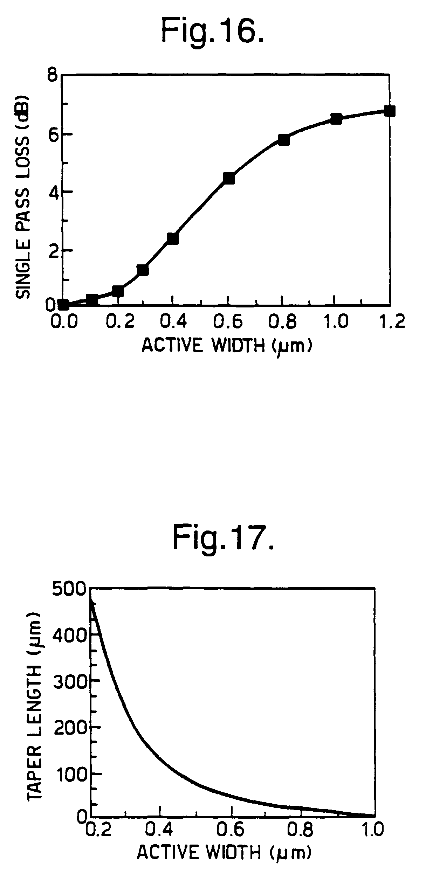

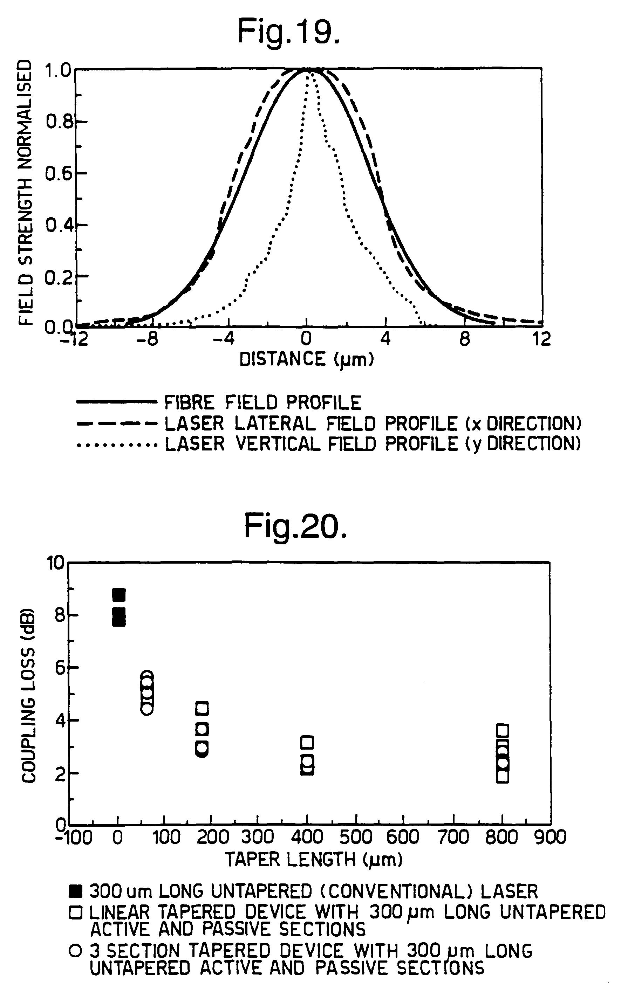

The active layer thickness is thus reduced from ≈ 0.27 μm for the 16 well to ≈ 0.17 μm for the 8 well active layer. These changes in waveguide design reduce the theoretically calculated truncation loss as a function of active width, (see Figure 16), allowing the truncation width to be increased to 0.2 μm. However the taper length as a function of active width was also increased, (see Figure 17), due to the smaller index difference between the guided and substrate modes. The net effect of this was a small decrease in taper length to ≈ 500 μm for the device. This device was calculated to have a lateral e-field modal size equal to that of 10μm core, cleaved fibre, see Figure 19. The mode size was calculated using a variable grid finite difference method. The calculated overlap between the calculated fields suggests a coupling loss of 0.7dB should be obtained. The fabricated device was measured to have a minimum coupling loss, for the 800μm taper device, of 1.8dB, see Figure 20. The higher measured coupling loss is due to the model underestimating the lateral mode size of the device. While this resulted in lower coupling efficiency it gave larger alignment tolerances. The lateral 3dB alignment tolerance measured experimentally was +5.5μm rather than the 3.5μm one would expect theoretically. It can be seen that this increase in alignment tolerance is of benefit because it further increases the ease of passive alignment. The fact that the mode is oversized is confirmed by the measured farfield FWHM for this device of 5.5° by 10° (10μm cleaved fibre has a FWHM of ≈ 7.5° at 1.55μm wavelength). In order to slightly reduce this oversized mode, a device in which the passive guide has been strengthened slightly has been fabricated. This device has a passive region which is 5μm wide by 800Å thick, while still retaining an 8 well MQW active region. As can be seen from Figure 21, this has resulted in a further reduction of coupling loss to ≈ 1.2 db, for the 800μm taper device.

**Claims**

1. A semiconductor optical device comprising a composite optical waveguide (1,2) having first and second end surfaces (18,19), the composite waveguide comprising:-

    a first optically waveguiding region (2) of semiconductor material, which first region (2) is optically passive and is substantially planar, and
    a second optically waveguiding region (1) of semiconductor material, which second region (1) is optically active, and is tapered along a substantial part of the length of the second region (1), from the first end surface (18) to the second end surface (19) of the composite waveguide, in a direction substantially parallel to the plane of the first region (2),
    wherein the first and second regions (2, 1) are in optical contact, and wherein the first region (2) is of substantially constant width along the length along the length of the composite waveguide characterised in that the second region (1) comprises a multi-quantum well structure, and in that the dimensions and the refractive indices of the first and second waveguiding regions (2, 1) are selected so that the size of the fundamental optical mode supported by the composite waveguide increases along the length of the composite waveguide (1,2).

2. A semiconductor optical device as claimed in claim 1, wherein the first optically passive region (2) is of substantially constant cross section along the length of the composite waveguide (1,2).

**3.** A semiconductor optical device as claimed in claim 1 or 2, wherein the first optically passive region (2) is of substantially rectangular cross section along the length of the composite waveguide (1,2).

**4.** A semiconductor optical device as claimed in claim 1, 2 and 3, wherein the multi-quantum well structure comprises at least eight quantum wells.

**5.** A semiconductor optical device as claimed in claim 1, 2 and 3, wherein the multi-quantum well structure comprises at least sixteen quantum wells.

**6.** A semiconductor optical device as claimed in any preceding claim, wherein the multi-quantum well structure is strained due to a lattice mismatch between the barrier and well semiconductor material.

**7.** A semiconductor optical device as claimed in any preceding claim, wherein the first optically passive region (2) extends beyond the second optically active region (1) towards the second end (19) of the composite waveguide.

**8.** A semiconductor optical device as claimed in any preceding claim, wherein the length of the first region (2) is greater than the length of the part of the second region (1) which is tapered.

**9.** A semiconductor optical device as claimed in any preceding claim, wherein the second optically active region (1) is tapered (4) along at least 5% of its length.

**10.** A semiconductor optical device as claimed in any preceding claim, wherein the second optically active region (1) is tapered (4) along at least 10% of its length.

**11.** A semiconductor optical device as claimed in any preceding claim, wherein the second optically active region (1) is tapered (4) along less than 80% of its length.

**12.** A semiconductor optical device as claimed in any preceding claim, wherein the second optically active region (1) is tapered (4) along substantially the whole of its length.

**13.** A semiconductor optical device as claimed in any preceding claim, wherein the tapered part (14) of the second optically active region (1) is truncated.

**14.** A semiconductor optical device as claimed in claim 13, wherein the width of the truncated end of the tapered optically active region (4) is at least 0.1µm.

**15.** A semiconductor optical device as claimed in claim 14, wherein the width of the truncated end of the tapered optically active region (4) is at least 0.3µm.

**16.** A semiconductor optical device as claimed in any preceding claim, wherein the second optically active region (1) is linearly tapered.

**17.** A semiconductor optical device as claimed in any preceding claim, wherein the material wavelength of the semiconductor material of the second optically active region (1) is greater than the material wavelength of the semiconductor material of the first optically passive region (2).

**18.** A semiconductor optical device as claimed in any preceding claim, wherein the thickness of the first optically passive region (2) is in the range 0.01µm to 0.4 µm.

**19.** A semiconductor optical device as claimed in any preceding claim, wherein the width of the first optically passive region (2) is in the range 2µm to 8µm.

**20.** A semiconductor device as claimed in any preceding claim comprising a buried heterostructure laser.

**21.** A method for making a semiconductor optical device according to claim 1, the method comprising the steps of:-

1) epitaxially growing a planar wafer on a substrate (5), the wafer comprising an optically waveguiding active region (9) above an optically waveguiding passive region (7);

2) defining a first mesa comprising the optically waveguiding active region (9);

3) forming a mask (12) on the first mesa, the width of the mask (12) being less than the width of said first mesa, the mask width varying along the length of the mask (12); and

4) defining a second mesa, of substantially the same width as the first mesa said width of the second mesa being substantially constant along its length, which second mesa comprises the optically waveguiding passive region (7), and redefining the first mesa to correspond to the mask (12).

**22.** A method for making a semiconductor optical device as claimed in claim 21, further comprising the further steps of:-

5) reducing the width of the active region (9) by etching with a selective etchant; and

6) performing a heat treatment sufficient to cause material transport.

**23.** A method for making a semiconductor optical device as claimed in claim 21 or claim 22, further comprising the steps of:-

7) performing a first stage overgrowth to form optical and electrical confinement layers (13,14) along the sides of said first and second mesas; and

8) performing a second stage overgrowth over the first and second mesas.

**24.** A method for making a semiconductor optical device as claimed in any one of claims 21 to 23, wherein any one of steps 1), 7) or 8) is carried out using metal organic vapour phase epitaxy.

**Patentansprüche**

**1.** Optische Halbleitervorrichtung mit einem zusammengesetzten optischen Wellenleiter (1, 2) mit einer ersten und einer zweiten Endfläche (18, 19), wobei der zusammengesetzte Wellenleiter umfaßt:

einen ersten optischen Wellenleiterbereich (2) aus Halbleitermaterial, wobei dieser erste Bereich (2) optisch passiv und im wesentlichen planar ist, und einen zweiten optischen Wellenleiterbereiche (1) aus Halbleitermaterial, wobei dieser zweite Bereich (1) optisch aktiv ist und konisch über einen wesentlichen Teil der Länge des zweiten Bereichs (1) von der ersten Endfläche (18) zur

zweiten Endfläche (19) des zusammengesetzten Wellenleiters in einer Richtung zusammenläuft, die im wesentlichen parallel zur Ebene des ersten Bereichs (2) ist,

wobei der erste und zweite Bereich (2, 1) optisch miteinander verbunden sind und wobei der erste Bereich (2) eine im wesentliche konstante Breite über die Länge des zusammengesetzten Wellenleiters hat, dadurch gekennzeichnet, daß

der zweite Bereich (1) eine Multi-Quantum-Well-Struktur aufweist und daß die Dimensionen und die Brechungsindizes des ersten und zweiten Wellenleiterbereichs (2, 1) so gewählt sind, daß die Größe der fundamentalen optischen Mode, die durch den zusammengesetzten Wellenleiter bevorzugt wird, entlang der Länge des zusammengesetzten Wellenleiters (1, 2) zunimmt.

**2.** Optische Halbleitervorrichtung nach Anspruch 1, bei der der erste optisch passive Bereich (2) einen im wesentlichen konstanten Querschnitt entlang der Länge des zusammengesetzten Wellenleiters (1, 2) aufweist.

**3.** Optische Halbleitervorrichtung nach Anspruch 1 oder 2, bei der der erste optisch passive Bereich (2) im wesentlichen einen rechteckigen Querschnitt entlang der Länge des zusammengesetzten Wellenleiters (1, 2) aufweist.

**4.** Optische Halbleitervorrichtung nach Anspruch 1, 2 oder 3, bei der die Multi-Quantum-Well-Struktur wenigstens acht Quantum-Well-Elemente aufweist.

**5.** Optische Halbleitervorrichtung nach Anspruch 1, 2 oder 3, bei der die Multi-Quantum-Well-Struktur wenigstens sechzehn Quantum-Well-Elemente aufweist.

**6.** Optische Halbleitervorrichtung nach einem der vorangehenden Ansprüche, bei der die Multi-Quantum-Well-Struktur durch eine Gitterfehlanpassung zwischen dem Barriere- und Well-Halbleitermaterial einer mechanischen Beanspruchung ausgesetzt ist.

**7.** Optische Halbleitervorrichtung nach einem der vorangehenden Ansprüche, bei der sich der erste optisch passive Bereich (2) über den zweiten optisch aktiven Bereich (1) in Richtung auf das zweite Ende (19) des zusammengesetzten Wellenleiters erstreckt.

**8.** Optische Halbleitervorrichtung nach einem der vorangehenden Ansprüche, bei der die Länge des ersten Bereichs (2) größer als die Länge des Teils des zweiten Bereichs (1) ist, der konisch zusammenläuft.

**9.** Optische Halbleitervorrichtung nach einem der vorangehenden Ansprüche, bei der der zweite optisch aktive Bereich (1) über wenigstens 5 % seiner Länge konisch (4) zusammenläuft.

**10.** Optische Halbleitervorrichtung nach einem der vorangehenden Ansprüche, bei der der zweite optisch aktive Bereich (1) über wenigstens 10 % seiner Länge konisch (4) zusammenläuft.

**11.** Optische Halbleitervorrichtung nach einem der vorangehenden Ansprüche, bei der der zweite optisch aktive Bereich (1) über weniger als 80 % seiner Länge konisch (4) zusammenläuft.

**12.** Optische Halbleitervorrichtung nach einem der vorangehenden Ansprüche, bei der der zweite optisch aktive Bereich (1) über im wesentlichen seine gesamte Länge konisch (4) zusammenläuft.

**13.** Optische Halbleitervorrichtung nach einem der vorangehenden Ansprüche, bei der der konisch zusammenlaufende Teil (14) des zweiten optisch aktiven Bereichs (1) abgeschnitten ist.

**14.** Optische Halbleitervorrichtung nach Anspruch 13, bei der die Breite des abgeschnittenen Endes des konisch zusammenlaufenden optisch aktiven Bereichs (4) wenigstens 0,1 $\mu$m beträgt.

**15.** Optische Halbleitervorrichtung nach Anspruch 14, bei der die Breite des abgeschnittenen Endes des konisch zusammenlaufenden optisch aktiven Bereichs (4) wenigstens 0,3 $\mu$m beträgt.

**16.** Optische Halbleitervorrichtung nach einem der vorangehenden Ansprüche, bei der der zweite optisch aktive Bereich (1) linear konisch zusammenläuft.

**17.** Optische Halbleitervorrichtung nach einem der vorangehenden Ansprüche, bei der die Materialwellenlänge des Halbleitermaterials des zweiten optisch aktiven Bereichs (1) größer als die Materialwellenlänge des Halbleitermaterials des optisch passiven Bereichs (2) ist.

**18.** Optische Halbleitervorrichtung nach einem der vorangehenden Ansprüche, bei der die Dicke des ersten optisch passiven Bereichs (2) im Bereich von 0,01 $\mu$m bis 0,4 $\mu$m liegt.

**19.** Optische Halbleitervorrichtung nach einem der vorangehenden Ansprüche, bei der die Breite des ersten optisch passiven Bereichs (2) im Bereich von 2 $\mu$ bis 8 $\mu$m liegt.

**20.** Optische Halbleitervorrichtung nach einem der vorangehenden Ansprüche mit einem Buried-Heterostructure-Laser.

**21.** Verfahren zum Herstellen einer optischen Halbleitervorrichtung nach Anspruch 1 mit den Schritten:

1) epitaxiales Aufwachsen eines planaren Wafers auf ein Substrat (5), wobei der Wafer einen optisch aktiven Wellenleiterbereich (9) über einem optisch passiven Wellenleiterbereich (7) umfaßt,
2) Definieren eines ersten Mesa-Elements mit dem optisch aktiven Wellenleiterbereich (9),
3) Bilden einer Maske (12) auf dem ersten Mesa-Element, wobei die Breite der Maske (12) kleiner als die Breite des ersten Mesa-Elements ist und die Maskenbreite entlang der Länge der Maske (12) variiert, und
4) Definieren eines zweiten Mesa-Elements mit im wesentlichen derselben Breite wie bei dem ersten Mesa-Element, wobei die Breite des zweiten Mesa-Elements über seine Länge im wesentlichen konstant ist, wobei das zweite Mesa-Element den optisch passiven Wellenleiterbereich (7) umfaßt, und Neudefinieren des ersten Mesa-Elements entsprechend der Maske (12).

**22.** Verfahren zum Herstellen einer optischen Halbleitervorrichtung nach Anspruch 21 mit den weiteren Schritten:

5) Reduzieren der Breite des aktiven Bereichs (9) durch Ätzen mit einem selektiven Ätzmittel und

6) Durchführen einer Wärmebehandlung, die ausreicht, um Materialtransport zu bewirken.

**23.** Verfahren zum Herstellen einer optischen Halbleitervorrichtung nach Anspruch 21 oder 22 mit den weiteren Schritten:

7) Durchführen eines Überwachsens erster Stufe zur Bildung von optischen und elektrischen Begrenzungsschichten (13, 14) entlang der Seiten des ersten und zweiten Mesa-Elements und
8) Durchführen eines Überwachsens zweiter Stufe über dem ersten und zweiten Mesa-Element.

**24.** Verfahren zum Herstellen einer optischen Halbleitervorrichtung nach einem der Ansprüche 21 bis 23, wobei jeder der Schritte 1), 7) oder 8) unter Anwendung von metallorganischer Dampfphasenepitaxie durchgeführt wird.

**Revendications**

**1.** Dispositif optique à semiconducteurs comprenant un guide d'onde optique composite (1, 2) comportant des première et seconde surfaces d'extrémité (18, 19), le guide d'onde composite comprenant :

une première région de guidage optique d'onde (2) de matériau de semiconducteur, laquelle première région (2) est optiquement passive et est sensiblement plane, et
une seconde région de guidage optique d'onde (1) de matériau de semiconducteur, laquelle seconde région (1) est optiquement active et est effilée sur une partie substantielle de la longueur de la seconde région (1) depuis la première surface d'extrémité (18) jusqu'à la seconde surface d'extrémité (19) du guide d'onde composite, dans une direction sensiblement parallèle au plan de la première région (2),
dans lequel les première et seconde régions (2, 1) sont en contact optique, et dans lequel la première région (2) est de largeur sensiblement constante sur la longueur du guide d'onde composite, caractérisé en ce que la seconde région (1) comprend une structure à puits quantiques multiples, et en ce que les dimensions.et les indices de réfraction des première et seconde régions de guidage d'onde (2, 1) sont choisis de façon à ce que la taille du mode optique fondamental supporté par le guide d'onde composite augmente sur la longueur du guide d'onde composite (1,2).

**2.** Dispositif optique à semiconducteurs selon la revendication 1, dans lequel la première région optiquement passive (2) est de section transversale sensiblement constante sur la longueur du guide d'onde composite (1, 2).

**3.** Dispositif optique à semiconducteurs selon la revendication 1 ou 2, dans lequel la première région optiquement passive (2) est de section transversale sensiblement rectangulaire sur la longueur du guide d'onde composite (1, 2).

**4.** Dispositif optique à semiconducteurs selon la revendication 1, 2 et 3, dans lequel la structure à puits quantiques multiples comprend au moins huit puits quantiques.

**5.** Dispositif optique à semiconducteurs selon la revendication 1, 2 et 3, dans lequel la structure à puits quantiques multiples comprend au moins seize puits quantiques.

**6.** Dispositif optique à semiconducteurs selon l'une quelconque des revendications précédentes, dans lequel la structure à puits quantiques multiples est contrainte en raison d'un défaut d'adaptation de réseau entre le matériau de semiconducteur de barrière et de puits.

**7.** Dispositif optique à semiconducteurs selon l'une quelconque des revendications précédentes, dans lequel la première région optiquement passive (2) s'étend au-delà de la seconde région optiquement active (1) en direction de la seconde extrémité (19) du guide d'onde composite.

**8.** Dispositif optique à semiconducteurs selon l'une quelconque des revendications précédentes, dans lequel la longueur de la première région (2) est supérieure à la longueur de la partie de la seconde région (1) qui est effilée.

**9.** Dispositif optique à semiconducteurs selon l'une quelconque des revendications précédentes, dans lequel la seconde région optiquement active (1) est effilée (4) sur au moins 5 % de sa longueur.

**10.** Dispositif optique à semiconducteurs selon l'une quelconque des revendications précédentes, dans lequel la seconde région optiquement active (1) est effilée (4) sur au moins 10 % de sa longueur.

**11.** Dispositif optique à semiconducteurs selon l'une quelconque des revendications précédentes, dans lequel la seconde région optiquement active (1) est effilée (4) sur moins de 80 % de sa longueur.

**12.** Dispositif optique à semiconducteurs selon l'une quelconque des revendications précédentes, dans lequel la seconde région optiquement active (1) est effilée (4) sur pratiquement la totalité de se longueur.

**13.** Dispositif optique à semiconducteurs selon l'une quelconque des revendications précédentes, dans lequel la partie effilée (14) de la seconde région optiquement active (1) est tronquée.

**14.** Dispositif optique à semiconducteurs selon la revendication 13, dans lequel la largeur de l'extrémité tronquée de la région optiquement active effilée (4) est au moins de 0,1 μm.

**15.** Dispositif optique à semiconducteurs selon la revendication 14, dans lequel la largeur de l'extrémité tronquée de la région optiquement active effilée (4) est au moins de 0,3 μm.

**16.** Dispositif optique à semiconducteurs selon l'une quelconque des revendications précédentes, dans lequel la seconde région optiquement active (1) est effilée linéairement.

**17.** Dispositif optique à semiconducteurs selon l'une quelconque des revendications précédentes, dans lequel la longueur d'onde de matériau du matériau de semiconducteur de la seconde région optiquement active (1) est supérieure à la longueur d'onde de matériau du matériau de semiconducteur de la première région optiquement passive (2).

**18.** Dispositif optique à semiconducteurs selon l'une quelconque des revendications précédentes, dans lequel l'épaisseur de la première région optiquement passive (2) est dans la plage de 0,01 μm à 0,4 μm.

**19.** Dispositif optique à semiconducteurs selon l'une quelconque des revendications précédentes, dans lequel la largeur de la première région optiquement passive (2) est dans la plage de 2 μm à 8 μm.

**20.** Dispositif à semiconducteurs selon l'une quelconque des revendications précédentes, comprenant un laser à hétérostructure enterrée.

**21.** Procédé de réalisation d'un dispositif optique à semiconducteurs selon la revendication 1, le procédé comprenant les étapes consistant à :

1) mettre à croître par épitaxie une tranche plane sur un substrat (5), la tranche comprenant une région active de guidage optique d'onde (9) au-dessus d'une région passive de guidage optique d'onde (7),
2) définir une première mesa comprenant la région active de guidage optique d'onde (9),
3) former un masque (12) sur la première mesa, la largeur du masque (12) étant inférieure à la largeur de ladite première mesa, la largeur du masque variant sur la longueur du masque (12), et
4) définir une seconde mesa de sensiblement la même largeur que la première mesa, ladite largeur de la seconde mesa étant sensiblement constante sur sa longueur, laquelle seconde mesa comprend la région passive de guidage optique d'onde (7) et redéfinir la première mesa pour qu'elle corresponde au masque (12).

**22.** Procédé de réalisation d'un dispositif optique à semiconducteur selon la revendication 21, comprenant en outre les étapes supplémentaires consistant à :

5) réduire la largeur de la région active (9) par une gravure avec un agent de gravure sélectif, et
6) exécuter un traitement thermique suffisant pour provoquer le transport du matériau.

**23.** Procédé de réalisation d'un dispositif optique à semiconducteurs selon la revendication 21 ou la revendication 22, comprenant en outre les étapes consistant à :

7) exécuter une croissance supplémentaire de premier stade pour former des couches de confinement optique et électrique (13, 14) sur les côtés desdites première et seconde mesas, et

8) exécuter une croissance supplémentaire de second stade sur les première et seconde mesas.

24. Procédé de réalisation d'un dispositif optique à semiconducteurs selon l'une quelconque des revendications 21 à 23, dans lequel l'une quelconque des étapes 1), 7) ou 8) est exécutée en utilisant une épitaxie en phase vapeur organométallique.

# Fig.1.

# Fig.2.

# Fig.3.

# Fig.4.

# Fig.5a.

# Fig.5b.

# Fig.5c.

## Fig.5d.

## Fig.5e.

## Fig.6a.

## Fig.6b.

# Fig.6c.

# Fig.6d.

# Fig.7a.

# Fig.7b.

# Fig.8a.

# Fig.8b.

# Fig.9a.

17  16

p side metal

15

10   9

14

13

6

5

8   7

# Fig.9b.

17   p side metal

17

15

14

13

6

5

8   7

## Fig.10.

- ■ 800μm
- ● 400μm
- ▲ 180μm
- ◆ 60μm
- ○ NO TAPER

## Fig.11.

- ■ LINEAR TAPER
- ◆ 3 SECTION TAPER

## Fig.12.

COUPLED
POWER

o MINIMUM

▲ MEAN

o MAXIMUM

## Fig.13.

# Fig.14.

# Fig.15.

## Fig.16.

## Fig.17.

# Fig.18.

—— LOVES CALCULATED DATA
········ 3 SECTION APPROXIMATION
—— LINEAR TAPER

# Fig.21.

■ 300 um LONG UNTAPERED (CONVENTIONAL) LASER
☐ LINEAR TAPERED DEVICE WITH 300 μm LONG UNTAPERED ACTIVE AND PASSIVE SECTIONS
○ 3 SECTION TAPERED DEVICE WITH 300 μm LONG UNTAPERED ACTIVE AND PASSIVE SECTIONS

## Fig.19.

FIBRE FIELD PROFILE
LASER LATERAL FIELD PROFILE (x DIRECTION)
LASER VERTICAL FIELD PROFILE (y DIRECTION)

## Fig.20.

■ 300 um LONG UNTAPERED (CONVENTIONAL) LASER
□ LINEAR TAPERED DEVICE WITH 300 μm LONG UNTAPERED
   ACTIVE AND PASSIVE SECTIONS
○ 3 SECTION TAPERED DEVICE WITH 300 μm LONG
   UNTAPERED ACTIVE AND PASSIVE SECTIONS